(19) Europäisches Patentamt
European Patent Office
Office européen des brevets

(11) Veröffentlichungsnummer: **0 231 858**
**A2**

(12) # EUROPÄISCHE PATENTANMELDUNG

(21) Anmeldenummer: **87101083.1**

(51) Int. Cl.⁴: **G11B 7/24**, G11B 11/10

(22) Anmeldetag: **27.01.87**

(30) Priorität: **04.02.86 DE 3603267**

(43) Veröffentlichungstag der Anmeldung: **12.08.87 Patentblatt 87/33**

(84) Benannte Vertragsstaaten: **DE FR GB IT NL**

(71) Anmelder: **Röhm GmbH**
**Kirschenallee Postfach 4242**
**D-6100 Darmstadt 1(DE)**

(72) Erfinder: **Eich, Manfred**
**Bockenheimer Landstrasse 7**
**D-6000 Frankfurt 1(DE)**
Erfinder: **Wendorff, Joachim, Dr.**
**Reiherstrasse 18**
**D-6085 Nauheim(DE)**

(54) **Vorrichtung zur reversiblen, optischen Datenspeicherung (I).**

(57) Die Erfindung betrifft eine Vorrichtung zur reversiblen optischen Datenspeicherung unter Verwendung von polymeren Flüssigkristallen mit mesogenen Seitengruppen als Speichermedium, eingerichtet zum Einspeichern von Information mittel selektiver Variation der Ordnung der polymeren Flüssigkristalle mittels einer Wärmequelle, wobei sich der makroskopisch orientierte Film aus dem flüssigkristallinen Polymeren zu Zweck des Einspeicherns der Information im Temperaturbereich unterhalb der Glastemperatur $T_g > T_a$ (Raumtemperatur) im festen formstabilen Zustand des flüssigkristallinen Polymeren befindet, vermittels der Wärmequelle selektiv, lokal in den isotrop flüssigen Zustand aufgeheizt wird und nach Abschalten der Wärmequelle die örtliche Information im Glaszustand des Polymeren fixiert wird.

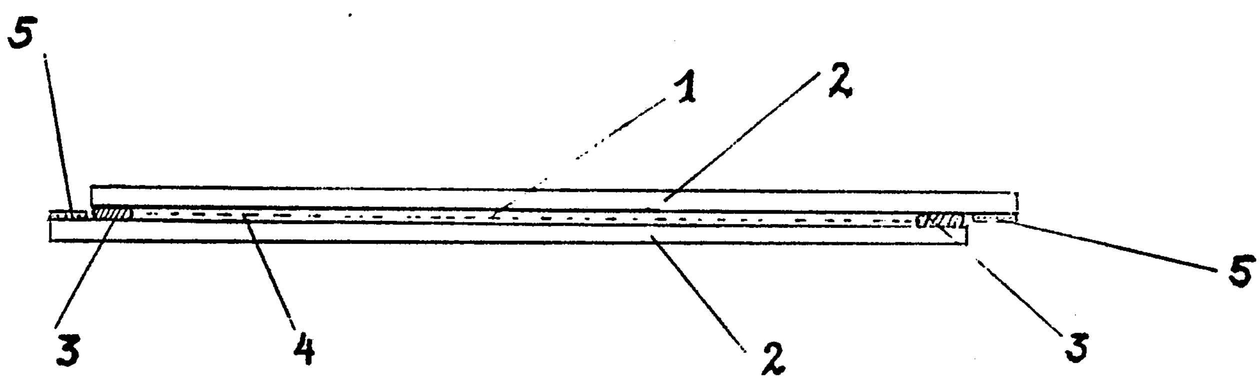


FIG. 1

EP 0 231 858 A2

Xerox Copy Centre

# Vorrichtung zur reversiblen, optischen Datenspeicherung (I)

## Gebiet der Erfindung

Die Erfindung betrifft eine Vorrichtung zur reversiblen, optischen Datenspeicherung unter Verwendung von polymeren Flüssigkristallen.

## Stand der Technik

Thermotrope Flüssigkristalle werden allgemein als stark anisotrope Flüssigphasen betrachtet, die zwischen der festen Phase und der isotrop flüssigen Phase existieren. Die Anisotropie der Phase ist eine Folge der langreichweitigen Orientierungsfernordnung der molekularen Bausteine. Die geometrische Form der molekularen Bausteine von Substanzen mit flüssigkristallinen Phasen ist bereits stark anisotrop. Die Moleküle besitzen z. B. ein Verhältnis Länge zu Dicke von über drei und können teilweise als starre Stäbchen betrachtet werden. Diese Strukturanisotropie bewirkt in der Regel eine uniaxiale Molekülorientierung innerhalb von Domänen. Während für die festen Kristalle ein dreidimensionales Ordnungsprinzip gilt, sind die molekularen Einheiten der Flüssigkristalle zwei-oder eindimensional geordnet. Strukturelle Unterschiede gestatten eine Einteilung der flüssigkristalline Phasen in a) smektische, b) nematische, c) cholesterische Phasen und d) diskotische Phasen. (Vgl. Ullmanns Encyklopaedie der Techn. Chemie, 4. Auflage , Bd. 11.)

Smektische Phasen a) zeigen einen zweidimensionalen Schichten-Aufbau wobei die Schichten leicht gegeneinander verschoben werden können. Nematische Phasen b) sind durch eine Parallelorientierung der Molekül längsachsen gekennzeichnet, wobei der seitliche Zusammenhalt zwischen den Molekülen gering ist, so daß die Moleküle frei aneinander vorbeigleiten können. Eine Parallelorientierung der Moleküle in nematischen Phasen über größere Bereiche hinweg (z. B. in Anzeigesegmenten) erfordert zusätzlichen Energieaufwand z.B. in Form von magnetischen oder elektrischen Feldern. Bei der cholesterischen Mesophase c) sind zwar die Moleküllängsachsen parallel zueinander angeordnet, wie bei nematischen Phasen, so daß Schichten mit einheitlicher Vorzugsrichtung der Moleküle parallel zur Schichtebene vorhanden sind. Die Richtung der Moleküllängsachsen ändert sich jedoch von Schicht zu Schicht in helikaler Weise. Zur Charakterisierung der thermodynamischen Stabilität flüssigkristalliner Phasen gibt man häufig den **Klärpunkt** an, d. h. diejenige Temperatur, bei der die anisotrope in die isotrope flüssige Phase übergeht. Vielfach zeigen Flüssigkristalle Polymorphie, d. h. sie können mehr als eine Art von mesomorpher Stuktur annehmen, z. B. in Abhängigkeit von Temperatur, Zusammensetzung und/oder verwendetem Lösungsmittel z. B. bei lyotropen Systemen. Die Technik hat sich die Eigenschaften niedermolekularer Flüssigkristalle für eine Reihe von Anwendungen zunutze gemacht. Besondere Bedeutung hat die Anwendung elektrooptischer Effekte auf dem Gebiet der Anzeigen (Armbanduhren, Taschenrechner, digitale Meßgeräte, Großanzeigen) gewonnen. Die meisten Flüssigkristalle sind sehr empfindlich gegenüber äußeren Einflüssen, so daß sie im allgemeinen von der Umwelt abgeschirmt, d. h. versiegelt werden müssen.

In den letzten Jahren hat man erkannt, daß auch bestimmte Typen von Polymeren die Eigenschaften von Flüssigkristallen besitzen und thermotrope Mesomorpie aufweisen können. Dabei können a) die mesogenen Einheiten Bestandteile der Polymerhauptkette sein oder b) die mesogenen Gruppen können über flexible, abstandhaltende Strukturelemente (Spacer) als Seitengruppen dem Polymerverband angehören.

Flüssigkristalline Polymere vereinen Eigenschaften von Flüssigkristallen und Polymeren. Durch die Demobilisierung der flüssigkristallinen Gruppen wird meist eine Stabilisierung der Mesophasen erzielt - (höhere Klärtemperaturen); andererseits können im Glaszustand geeigneter Polymeren anisotrope Phasen eingefroren werden.

Wie niedrigmolekulare Systeme bilden flüssigkristalline Polymere temperaturabhängig nematische, cholesterische, smektische Mesophasen oder diskotische Phasen aus. Im Gegensatz zu niedrigmolekularen Flüssigkristallen, die beim Abkühlen vom flüssigkristallinen in den kristallinen Zustand übergehen, weisen manche flüssigkristallinen Polymeren einen Übergang des mesophasischen in den Glaszustand auf. Beim Übergang in den Kristallzustand wird der flüssig-kristalline Ordnungszustand aufgehoben, wobei hingegen im Glaszustand die flüssigkristalline Anordnung im wesentlichen beibehalten wird. (anisotrope Gläser). Der Glaszustand wird wie üblich durch die Glastemperatur ($T_g$; Vgl. Brandrup-Immergut; Polymer-Handbook, Vieweg-Esser, KunststoffHandbuch, Bd. IX, Pg. 333 -340, C. Hanser-Verlag (1975)) festgelegt.

Technische Anwendung haben bisher hauptsächlich Polymere mit flüssigkristallinen Gruppen in der Hauptkette gefunden. Hierbei führt die Parallelanordnung dieser Gruppen zu in Längsrichtung stark orientierten Fasern, z. B. aromatischen Polyamidfasern,mit außerordentlich hoher Festigkeit und hoher thermischer Stabilität. (Vgl. Kirk-Othmer, Encyclopedia of Chemical Technology, 3rd Ed., Vol. 14, pg 414 - 421 (1981). Auch die Polymeren mit mesogenen Seitengruppen fanden in jüngster Zeit starke Beachtung - (Vgl. S. B. Clough, A. Blumstein & E.C. Hsu, Macromolecules 9, 123 (1976); V.N. Tsekov et al. Europ. Polymer I. 9, 481 (1973); L. Strzelecky& L. Libert, Bull. Soc. Chim. France 297 (1973); H. Finkelmann in "Polymer Liquid Crystals", Academic Press, 1982; J. Frenzel, G. Rehage, Macromol. Chem 184, 1689 - 1703 (1983; Makromol, Chem, Rapid Commun. 1, 129 (1980); D. Hoppner, J.H. Wendorff, Die Angewandte Makromolekulare Chemie 125, 37 -51 (1984).

Aus der US-A 4 293 435 ist eine technische Nutzung des spezifischen Verhaltens der flüssigkristallinen Polymere, das mit dem Übergang in den Glaszustand verbunden ist, bekannt. Dabei wird durch Anwendung von Bedingungen, die in definierter Weise Anordnung der Orientierung der flüssigkristallinen Polymeren verändern (wie z. B. elektrisches und magnetisches Feld bzw. Druck) Information gespeichert. Dieser Stand der Technik wird in der GB-A 2 146 787 diskutiert. Es wird darauf hingewiesen, daß die in der US-A vorgesehene Lagerung der Vorrichtung im Festzustand unterhalb Glastemperatur ($T_g$) bedeutet, daß $T_g$ oberhalb der üblichen Raumtemperatur ($T_a$) liegt, d. h. daß das Polymersystem bei Temperaturen zur Anwendung kommt, die in der Größenordnung von 100°C über $T_a$ liegen, will man innerhalb vernünftiger Zeiten die Information aufnehmen. Solche Temperaturen seien unhandlich und brächten auf längere Sicht einen Abbau des Polymeren mit sich. Diese Schwierigkeiten lassen sich nach der GB-A vermeiden, wenn man bestimmte polymere Seitenketten-Flüssigkristalle verwendet. Dann ist es nicht länger notwendig,zur Aufbewahrung der Vorrichtung einen Temperaturbereich unterhalb der $T_g$ einzuhalten, sondern eine stabile Speicherung über viele Jahre hinweg soll bei Temperaturen oberhalb $T_g$und unterhalb einer Temperatur - ($T_f$), bei der das Polymermaterial flüssig zu werden beginnt,möglich sein.
Die Bestimmung der $T_f$ kann durch Verfolgung des Lichtdurchgangs durch ein flüssigkristallines Polymer zwischen zwei gekreuzte Polarisationsfiltern mit ab Glastemperatur ansteigender Temperatur vorgenommen werden. Einige Grade unterhalb des smektisch-isotropen Phasenübergangs steigt die Lichtdurchlässigkeit plötzlich an. Dieser Anstieg rührt vom Übergang eines anisotropen aber wenig durchlässigen zu einem hochgradig doppelbechenden, durchlässigen Zustand des Bereichs her. Der Temperaturbereich oberhalb dieser Temperatur $T_f$ wird als "flüssiger Bereich" (fluid region) bezeichnet. Mit steigender Temperatur steigt auch die Lichtdurchlässigkeit an, bis sie bei einer $T_m$ ihr Maximum erreicht. Die $T_m$ markiert den Punkt, an dem die isotrope (Klar-)Phase zuerst auftritt.

Da das Auftreten der isotropen Phase bei gekreuzten Polarisatoren zu einer Extinktion des Lichts führt, bringt eine weitere Temperaturerhöhung einen Abfall des Lichtdurchtritts in dem Maße mit sich, wie die isotropen Bezirke in der Größe anwachsen, bis die sogenannte Klärtemperatur ($T_c$) erreicht ist, bei der die letzten Reste der für die Doppelbrechung verantwortlichen Struktur verschwunden sind.

In der GB-A 2 146 787 wird eine Vorrichtung beansprucht mit einer Materialschicht, die ein flüssigkristallines Polymeres mit mesogener Seitenkette enthält, sowie Einrichtungen zum thermischen Überführen mindestens eines Teils des Materials aus dem viskosen Zustand, bei dem sich die Temperatur des Materials im Bereich $T_g$ bis $T_f$ befindet, in den flüssigen Bereich und Einrichtungen zur Beeinflussung mindestens eines Teils des Materials im flüssigen Bereich, womit man eine selektive Veränderung in der Textur der Moleküle im Material hervorruft und dadurch Information eingibt, die auch nach Abkühlung des flüssigen Bereichs und Rückkehr in den viskosen Zustand erhalten bleibt. Für die GB-A ist es somit eine essentielle Voraussetzung, Polymermaterial zu verwenden für das gilt: $T_f > T_a > T_g$. Ferner wird eine Vorrichtung beschrieben, in der die Materialschicht ein flüssigkristallines Polymer mit einer smektogenen Seitenkette enthält. Besonders bevorzugt sind polymere Flüssigkristalle vom Polysiloxan-Typ mit Diphenylcyan-Seitenketten oder Benzoesäureester-Seitenketten.

## Aufgabe und Lösung

Nach wie vor besteht ein großes Interesse an optischen Speichermedien, die neben hohen Aufzeichnungsdichten auch die Möglichkeit zur reversiblen Speicherung besitzen. Die vorstehend erläuterten Lösungen des Problems der optischen Datenspeicherung stellen relativ eng begrenzte technische Lösungen dar. So beruht die Vorrichtung gemäß der GB-A auf der Anwendung von flüssigkristallinen Seitenkettenpolymeren mit der essentiellen Voraussetzung, daß die Temperatur so gewählt wird, daß das Polymermaterial in einem viskosen Zustandsbereich gehalten wird. Die differenzierte Offenbarung erstreckt sich auf Polysiloxan-Flüssigkristalle, vorzugsweise mit Diphenylcyan-oder Benzoesäureester-Seitenketten.

Die Stabilität der eingespeicherten Information ist wegen der vorhandenen Molekülbeweglichkeit und der endlichen Relaxationszeiten als auch der die Möglichkeit der Beeinflussung des Systems z. B. durch Störfelder, nicht eindeutig gewährleistet. Zu wünschen waren weiterhin technische Lösungen, deren Realisierung innerhalb eines nicht zu engen Spielraums durchführbar sein sollte.

Es wurde nun gefunden, daß eine besonders günstige Form der optischen Datenspeicherung erreicht werden kann durch Anwendung der erfindungsgemäßen Vorrichtung.

Die erfindungsgemäße Vorrichtung enthält ein Speichermedium aus polymeren Flüssigkristallen mit mesogenen Seitengruppen und ist eingerichtet zum Einspeichern der Information mittels selektiver Variation der räumlichen Ordnung und/oder Orientierung der polymeren Flüssigkristalle , wobei sich der die polymeren Flüssigkristalle enthaltende, makroskopisch orientierte Film, in den zum Einspeichern der Information vorbereiteten Zustand, d. h. beim Einspeichern der Information im formstabilen Bereich unterhalb der Glastemperatur $T_g$ des polymeren Flüssigkristalls befindet und die selektive Variation der räumlichen Anordnung und/oder Orientierung der polymeren Flüssigkristalle vorzugsweise mittels Laserbestrahlung lokal vorgenommen wird, wonach der die Information enthaltende lokale Ordnungszustand nach Abschalten des Laserstrahls in den Temperaturbereich unterhalb von $T_g$ der polymeren Flüssigkristalle eingefroren bleibt.

Bei der vorliegenden Erfindung wird demnach von einem jederzeit formstabilen Speichermedium ausgegangen, das die polymeren Flüssigkristalle enthält.

Die Anforderung an die Struktur der flüssigkristallinen Polymere für die verschiedenen Orientierungsverfahren sind in der Literatur dokumentiert. So erfordert zum Beispiel eine homöotrope Orientierung im elektrischen Feld eine positive Dielektrizitätsanisotropie für den verwendeten Frequenzbereich. Eine homogene Orientierung hingegen läßt sich häufig durch Begrenzungsoberflächen aus strukturiertem Polyimid erzeugen. Hierfür sind mesogene Gruppen mit anisotroper Form erforderlich.

Vgl. R. Kelker, R. Hatz Handbook of Liquid Crystals Verlag Chemie 1981. Vgl. Pranoto, W. Haase Mol. Cryst. Liq. Cryst. 98, 299 -308 (1983) R. Zentel, R. Ringsdorf Makromol. Chem. 182, 1245 -1256 (1982) Vgl. Liquid Crystals und Ordered Fluids A. Griffin, J.F. JohnsenVol. 4, Plenum Press, New York 1984.

Die erfindungsgemäß verwendbaren polymeren Flüssigkristalle PFK bestehen ganz oder teilweise aus repetierenden Einheiten, die schematisch durch die allgemeine Formel I

$$-\left[ A - \underset{\substack{| \\ X - Y}}{B} \right]- \qquad \text{I}$$

wiedergegeben werden können, wobei A -B die Elemente der Hauptkette des Polymerisats, X eines abstandhaltende Einheit ("Spacer") und Y eine mesogene Seitengruppe bezeichnet.

Dabei sind die mesogenen Seitengruppen verantwortlich für den resultierenden Flüssig-Kristall-Charakter. Von besonderem Interesse sind Seitenketten vom smektogenen Typ.

Die Elemente A -B entsprechen dabei vorzugsweise radikalisch polymerisierbaren Einheiten A' = B' (entsprechendes Monomeres: A' = B' -X -Y) Bevorzugt handelt es sich bei den Einheiten A' -B' um Vinylgruppen, wie sie in den radikalisch polymerisierbaren Vinylverbindungen vorliegen, zum Beispiel um Einheiten

$$H_2C = \overset{\substack{R_1 \\ |}}{C} - Q -$$

worin $R_1$ für Wasserstoff oder Methyl und Q für eine die Doppelbindung aktivierende Funktion wie die Gruppe

$$-\overset{\substack{O \\ \|}}{C} - O -; \quad -\overset{\substack{O \\ \|}}{C} - \overset{\substack{R_2 \\ |}}{N} -; \quad -\overset{\substack{O \\ \|}}{C} -; \quad - C_6H_5 -$$

steht, worin $R_2$ die Bedeutung Wasserstoff oder Alkyl mit 1 bis 6 Kohlenstoffatomen besitzt.

Die Spacergruppe X stellt eine (flexible) Kette mit 1 -14 Kettengliedern dar, vorzugsweise eine Alkylengruppe $-(CH_2)_n-$worin n für 1 bis 14 steht, wobei gegebenenfalls einzelne Kettenglieder substituiert sein können, beispielsweise durch Halogen wie Chlor oder durch eine Ätherbrücke ersetzt sein können.
Die mesogenen Seitenkette Y enthält gegebenenfalls eine die Spacergruppe X mit der eigentlichen mesogenen Gruppe M verknüpfende Funktion V F wie z. B. eine

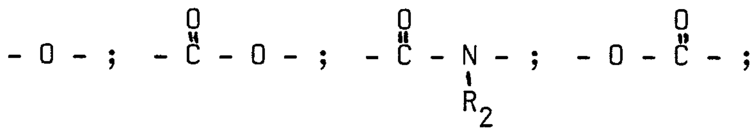

oder

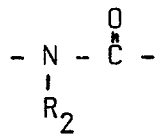

Gruppe, worin $R_2$ die oben beschriebene Bedeutung besitzt.

Weiter gilt für die mesogene Seitengruppe Y das folgende:
Eine Aufstellung geeigneter mesogener Gruppen findet sich in Kelker and Hatz, Handbook of Liquid Crystals, Verlag Chemie 1980, pp. 67 -113.
Vorzugsweise über die genannte verknüpfende Funktion VF gebunden ist eine beispielsweise aromatische Reste enthaltende mesogene Gruppe M, die vorzugsweise durch die Formel

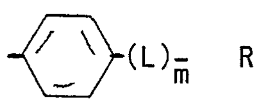

II

wiedergegeben werden kann, worin L für eine Brücke, bestehend aus den

Resten 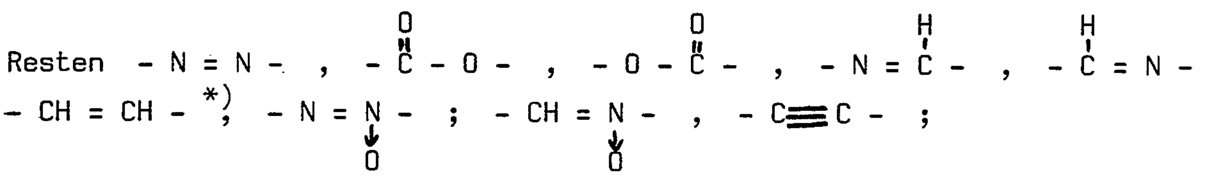

m für Null oder eins
und R für einen Rest

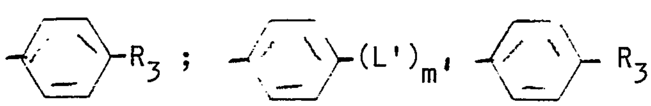

oder falls m für Null steht R auch für einen Rest

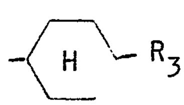

steht und L′ und m′ die gleichen Bedeutung wie L bzw. m besitzen und worin $R_3$ für Wasserstoff $(O)_r-(CH_2)_pH$, $-COO(CH_2)_{p'}H$, -CN oder Halogen, insbesondere Fluor, Chlor oder Brom und p und p′ für eine Zahl von 1 bis 8, insbesondere 1 bis 6, und r für Null oder 1 steht.

Besonders genannt seien Polymere der Formel I, worin M für die folgenden mesogenen Gruppen steht:

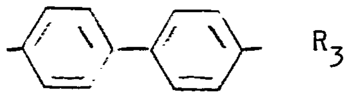 (Formel IA) ; 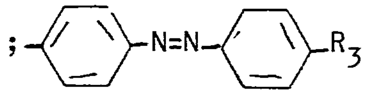 (Formel IB)

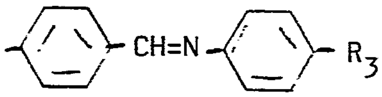 (Formel IC) ; 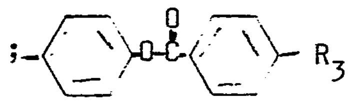 (Formel ID)

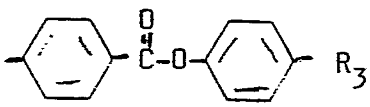 (Formel IE) ; 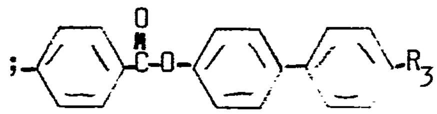 (Formel IF)

*) oder für einen Rest $- CH = N - \underset{CH_3}{CH} -$ , 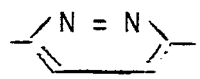 ,

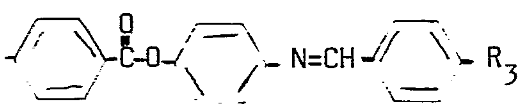 ; 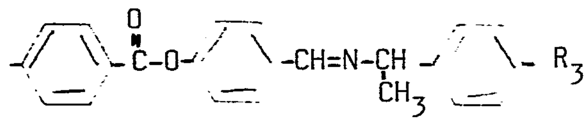

(Formel IG) (Formel IH)

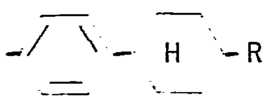 (Formel IJ)

Bevorzugt sind ferner Derivate der (Meth)acrylsäure (A' = B' -steht dabei für

$$CH_2 = \underset{R_1}{C} - CO - O \quad \text{bzw.} \quad CH_2 = \underset{R_1}{C} - CO - \underset{R_2}{N} - \; )$$

und solche Derivate, bei denen der Spacer X eine $-(CH_2)_n-$ Gruppe mit n = 1 -14 darstellt.
Die erfindungsgemäß anwendbaren polymeren Flüssigkristalle können auch das Produkt einer Polykondensation sein.
Genannt seinen insbesondere Polyester der Formel II

$$\left[ Q - OOC - \underset{XY}{CH} - COO \right] \qquad II$$

worin Q für einen (von dem Diol HO -Q - OH abgeleiteten) linearen Alkylrest oder einem paraständig alkylierten Aryl-insbesondere Phenylrest steht (vgl. z. B. B. Reck, H. Ringsdorf in Makromol. Chem. Rapid Commun. 6, 291 -299 (1985). Von Interesse ist ein Polymeres, das als mesogene Gruppe M einen Rest

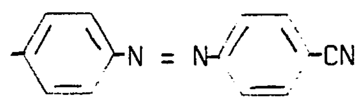

und als Spacer X einen $-(CH_2)_6$ -Rest besitzt. Als Rest Q seinen zum Beispiel die Gruppen $-(CH_2)_9$-oder

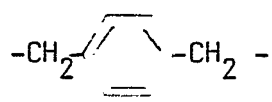

genannt.

Im allgemeinem liegt das Molekulargewicht der polymeren Flüssigkristalle PFK im Bereich $\bar{M}_w = 10^3$ bis $10^5$, im allgemeinen im Bereich 5000 -200000, vorzugsweise um 100 000 (Bestimmung durch Gel-Permeationschromatographie).

Die Viskositäten in der isotropen Phase liegen -als Richtwert -im Bereich $10^4$ Poise.

Die Glastemperatur ($T_g$) der erfindungsgemäß verwendeten flüssigkristallinen Polymeren liegt im allgemeinen im Bereich von -40 bis 110°C, insbesondere im Bereich von -10 bis 80°C. (Zur Glastemperatur $T_g$: Vgl. I. Brandrup und E.H. Immergut, Polymer Handbook 2nd Ed. III -139 J. Wiley, 1975)

Die Vorrichtung

Die Vorrichtung entspricht primär den im Hauptanspruch und vorstehend (Vgl. Aufgabe und Lösung) aufgestellten Merkmalen. Das für den Informationsspeicherprozeß vorgeschlagene flüssigkristalline Polymere ist in seinem Absorptionsverhalten auf die Wellenlänge des Schreiblasers anzupassen. Dies geschieht z.B. entweder durch Zumischen eines geeigneten Farbstoffs oder durch Einpolymerisieren desselben in die Polymerkette. Dabei kann das Farbstoffmolekül selbst mesogenen Charakter aufweisen. Vorzugsweise kann ein polymerer Flüssigkristall eingesetzt werden, dessen mesogene Gruppen selbst im geforderten Wellenlängenbereich absorbieren, der also dem Extremfall eines zu 100 % einpolymerisierten mesogenen Farbstoffs entspricht. Die erforderliche Extinktion des Speichermediums wird über die Farbstoffkonzentration eingestellt.

Geeignete Farbstoffe sind aus der Literatur bekannt. Als geeignete Farbstoffe zum Einmischen in die flüssigkristalline Phase werden solche genannt, die eine Reihe von Bedingungen erfüllen. (Vgl. z. B. J. Constant et al. , J. Phys D: Appl. Phys. Vol. 11 S. 479 ff (1978) F. Jones et al. Mol. Cryst. Liq. Crstal, Vol. 60, S. 99 ff, 1980, EP-A 43 904, EP-A 55 838, EP-A 65 869. Die Farbstoffe sollen unter der Wirkung eines elektr. Feldes nicht ionisieren, sollen einen möglichst hohen molekularen Extinktionskoeffizienten und gleichzeitig eine gute Löslichkeit in der verwendeten Flüssigkristallmatrix (d.h. dem Speichermedium) haben und müssen chemisch/photochemisch stabil sein. Farbstoffe mit entsprechenden Eigenschaften finden sich z. B. in der Klasse der Anthrachinone (Vgl. EP-A 56 492, EP-A 44 893, EP-A 59 036, EP-A 54 217).

Geeignete Azofarbstoffe werden z. B. in der DE-A 34 06 209 angegeben. Der Anteil der Farbstoffe an dem Speichermedium liegt vorteilhafterweise im Bereich 1 bis 50 Gew.-%.

Polymere mit mesogenen Gruppen und Farbstoffresten in den Seitenketten sind Gegenstand der EP-A 7 574, EP-A 90 282, EP-A 1 40 133 vgl. auch H. Ringsdorf, H.W. Schmidt Makromol. Chem. 185, 1327 -1334 (1984); B. Reck, H. Ringsdorf Makromol. Chem. Rapid Commun. loc. cit. Analog den vorstehend erläuterten polymeren Flüssigkristallen PFK der Formel I können repetierende Einheiten -A -B -die Hauptkettenelemente der farbstoffhaltigen Monomereinheiten bilden. Die entsprechenden Monomeren A' = B' -X -Y' enthalten demnach den Farbstoffrest in der Gruppe Y'.

Als Beispiel einer mesogenen Gruppe M, die gleichzeitig einen Farbstoffrest darstellt sei die Gruppe



genannt.

Vorteilhaft ist gleichzeitig eine Spacergruppe $-(CH_2)_6-$. Das Polymer kann im Prinzip in Form einer dünnen Schicht (Film) oder eines Laminats, als Beschichtung einer festen oder biegsamen Matrixschicht angewendet werden. Die Dicke des die polymeren Flüssigkristalle enthaltenden bzw. daraus bestehenden Films liegt vorteilhafterweise im Bereich $10^{-3}$ bis $10^{-6}$ m. In der hier angeführten Ausbildung (Vgl. Fig. 1) umfasst die erfindungsgemäße Vorrichtung eine Registrierzelle (1), bestehend aus zwei planparallel angeordneten transparenten Platten (2), vorzugsweise Glasplatten im geeigneten Abstand, im allgemeinen unterhalb 1 mm, vorzugsweise bei ca. 10 $\mu$m. Die Grundfläche beträgt einige $cm^2$ bis $dm^2$. Die beiden Innenflächen der Glasplatten (2) waren mit $InO_2/SnO_2$ leitfähig bedampft und leitender Kontakt nach außen war hergestellt worden. Die derart präparierten Glasplatten (2) wurden mit Hilfe eines temperaturstabilen Klebers, beispielsweise eines Silikonklebers so aneinander fixiert, daß ein zellenartiger leerer Innenraum mit jeweils nur einem Einlaß und Auslaß von einigen mm Breite gebildet wird.
Der gewünschte Abstand der beiden Glasplatten (2) wird dabei durch zwei geeignete Abstandshalter (3) der passenden Abmessung, vorzugsweise aus Polyimid-Kunststoff, fest eingestellt. Die Registrierzelle weist weiterhin Elektroden (4) auf. Nach Antrocken des Klebers wird die Zelle auf einer hiezbaren Einrichtung mit dem im isotropen Zustand befindlichen, flüssigkristallinen Polymeren, vorzugsweise der Formel I gefüllt. Durch Kapillarwirkung bedingt füllt sich so der noch freie Zellenraum vollständig mit der Polymerschmelze.

Der Vorteil des Vorgehens gegenüber der Verwendung einer noch teilweise offenen Zelle liegt u. a. darin, daß der Einschluß von Luftblasen zuverlässig verhindert wird. Außderdem können so mit geringem Aufwand standardisierte Zellen-Rohling mit innerhalb gewisser Grenzen variabler Geometrie - (Außenabmessungen, Distanzen) hergestellt werden, die (vgl. Fig. 1) dann bei Bedarf in einem zweiten Schritt in angegebener Weise mit den entsprechenden flüssigkristallinen Polymeren befüllt werden können. Die Orientierung erfolgt in an sich bekannter Weise durch Anlegen eines orientierten Felds (alignment field), insbesondere eines magnetischen und speziell eines elektrischen Felds oder über Oberflächeneffekte *. Im Falle der (bevorzugten) Anwendung des elektrischen Feldes wird an die so gefüllte Registrierzelle (1) bei Temperaturen von oberhalb $T_g$ (Definition siehe oben) eine sinusförmige Wechselspannung (Richtwerte V = 500 V; $\nu$ = 1 Khz) angelegt und unter Beibehaltung der angelegten Spannung auf Zimmertemperatur abgekühlt. Es resultiert ein absolut transparenter Flüssigkristallfilm, der sich rein visuelle nicht von den im isotropen Zustand befindlichen Material unterscheidet. Die Glastemperatur $T_g$ des flüssigkristallinen Polymeren liegt über der Raumtemperatur $T_a$. Als Raumtemperatur sei eine Temperatur von 20°C angenommen. Das Auslesen der Information kann durch Beleuchten des Polymerfilms mit monochromatischem kohärentem Licht erfolgen. Zur Einspeicherung der Information sind verschiedene Orientierungsmöglichkeiten des flüssigkristallinen Polymerfilms in der erfindungsgemäßen Vorrichtung (vgl. Fig. 1) möglich:

1) Die mesogenen Gruppen werden parallel zur Flächennormale der polymeren Filmschicht einheitlich ausgerichtet. Dies kann durch Anlegen eines elektrischen Wechselfeldes an die mit (transparenten) Elektroden beschichteten Platten (2), wobei das elektrische Feld parallel zur Normale der polymeren Filmschicht liegt, durch Anlegen eines Magnetfeldes oder durch Oberflächenbehandlung geschehen.

2) Die mesogenen Gruppen werden parallel zur Filmebene und parallel zu einer makroskopisch vorgegebenen Richtung orientiert. Dies kann entweder durch Beschichtung der Platten (2) mittels eines geeigneten Materials wie Polyimid und durch Strukturieren dieser Beschichtung entlang der gewünschten Vorzugsorientierung oder durch geeignete Schrägbedampfung der Substrate z. B. mit Siliziumoxid geschehen.

In beiden Fällen 1) und 2) erfolgt die Orientierung im flüssigkristallinen Zustand.
Die Orientierung wird durch Abkühlen in den Glaszustand eingefroren. Die wie oben angegeben hergestellte Registrierzelle (1) bildet das eigentliche Speichermedium für das Einspeichern optischer Information.

Prozeß der Informationsspeicherung

Die einfachste Art des Einschreibens von Information besteht im Prinzip in der Erzeugung von Streuzentren, mittels eines fokussierten Laserstrahls, der die orientierte, temperierte flüssigkristalline Polymerschicht lokal in die isotrope Phase überführt. Der lokal entstandene makroskopische isotrope Bereich wird unterhalb der Glastemperatur eingefroren.
Vorteilhaft geht man dabei wie folgt vor:

* Ebenso kann die erforderliche Orientierung durch geeignetes Scheren oder Verstrecken erzeugt werden.

Der erfindungsgemäß aus dem flüssigkristallinen Polymeren gebildete Film wird im Fokal-Bereich eines Abbildungssystems von Raumtemperatur ausgehend bis in die isotrope Phase lokal aufgeheizt. Verwendet wird ein fokussierter Laserstrahl, beispielsweise Licht mit der Wellenlänge 514,5 nm eines-Argon-Lasers.

Abschalten des Laserlichts und nachfolgendes Abkühlen führen zu den desorientierten (makroskopisch isotropen) Bereichen. Die dadurch erzeugten Streuzentren können als optische Information ausgelesen werden.

Der experimentelle Aufbau kann in Anlehnung an M. Eich, J.H. Wendorff Die Makromolekulare Chemie, Vol 186, No. 12, 2639 (1985) erfolgen.

Löschen der eingespeicherten Information

Grundsätzlich kann die eingespeicherte Information durch Temperaturerhöhung (über $T_g$) und Abkühlen im elektrischen oder magnetischen Feld wieder gelöscht werden. Vorteilhaft wird dabei wie folgt vorgegangen:

Analog der Vorbereitung für den ersten Einschreibvorgang wird die in den flüssigkristallinen Polymeren eingespeicherte Information durch Aufheizen der Registrierzelle (1) über $T_g$, vorzugsweise über $T_f$ und nachfolgendes Abkühlen bei angelegter Wechselspannung (Richtwerte 500 V, $\nu$ -1 Khz) gelöscht. Nachdem der Einschreib-und Löschvorgang mehrfach wiederholt worden war, stand fest, daß bei keinem der durchgeführten Schritte irreversible Veränderungen an der Registrierzelle auftreten.

Herstellung der flüssigkristallinen Polymeren

Die erfindungsgemäß anwendbaren Polymeren, insbesondere die der Formel I können auf an sich bekannte Weise hergestellt werden: Hingewiesen sei auf die DE-A 27 22 589, DE-A 28 31 909, DE-A 30 20 645, DE-A 30 27 757, DE-A 32 11 400, EU-A 90 282.

Typ: Direktverknüpfung Spacer -Mesogene Gruppe

Als Beispiel sei die Herstellung von Verbindungen des Typs IA beschrieben. (Vgl. V. P. Shibaev et al. Eur. Polym. J. 18, 651 (1982)). Soweit im weiteren Symbole verwendet wurden, entsprechen sie den oben angegebenen Bedeutungen. Dabei kann eine Verbindung der Formel III

$Br-(CH_2)_{n'}-COOH$ III

worin n' = n -1 bedeutet

mit einem anorganischen Säurechlorid wie $SOCl_2$ vorzugsweise in DMF,in die Verbindung IV überführt werden.

$Br-(CH_2)_n-COCl$ IV

Diese kann in einer Friedel-Crafts-Reaktion, beispielsweise in Nitrobenzol mit Diphenyl in die Verbindung der Formel V

$Br-(CH_2)_n-CO-C_6H_4-C_6H_5$ V

überführt werden, die sich z. B. mit Lithium-Aluminium-hydrid zur Verbindung VI reduziert

$Br-(CH_2)_n-C_6H_4-C_6H_5$ VI

Diese kann mit $Cl_2CHOC_4H_9$ und Titantetrachlorid zur Verbindung VII

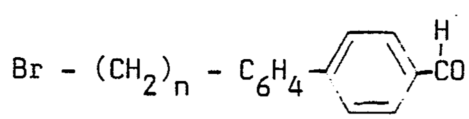

VII

umgesetzt werden. Die Verbindung VII kann mit Hydroxylamin-salz vorteilhafterweise in Anwesenheit einer Base wie Pyridin zum Oxim umgesetzt und dieses durch Wasserabspaltung, beispielsweise mit Hilfe eines Anhydrids wie Acetanhydrid in das Nitril VIII überführt werden

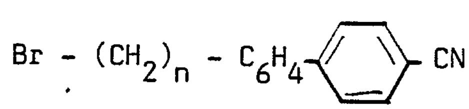

VIII.

Durch Umsetzung eines Salzes der (Meth)acrylsäure, beispielsweise im DMF mit Verbindung VIII erhält man die Verbindung vom Typ IAa

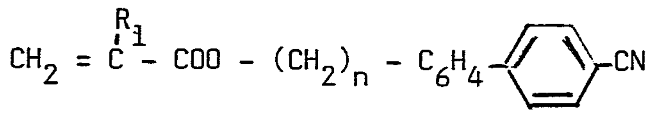 IAa

worin $R_1$ für Wasserstoff oder Methyl steht.

Umittelbar analog läßt sich z. B. aus der Verbindung V und einem Salz der (Meth)acrylsäure die Verbindung IAb

$CH_2 = C(R_1)$ $-COO-(CH_2)_n-C_6H_4-C_6H_5$ IAb

herstellen.

Typ: Verknüpfung Spacer -Mesogene Gruppe über eine Ätherbrücke. Als Beispiel sei die Herstellung einer Verbindung vom Typ IA beschrieben (vgl. V. P Shibaev loc. cit., N.A. Plate, V. P. Shibaev J. Polym. Sci. Polym. Sympos (IUPAC 1978) 67, 1 (1980)

Die Verbindung IV wird, z. B. mit Lithium-aluminiumhydrid in Äther zur Verbindung IX reduziert

$B-(CH_2)_n-OH$ IX

die mit der Verbindung XI

$KO-C_6H_4-C_6H_4-CN$ XI

beispielsweise in Methanol zur Verbindung XII umgesetzt wird

$HO-(CH_2)_n-O-C_6H_4-C_6H_4-CN$ XII

Die Hydroxyverbindung XII wird mit dem Chlorid der (Meth)acrylsäure in Anwesenheit eines Säureakzeptors wie z. B. einem tert. Amin in die Verbindung IAc überführt

$CH_2 = C(R_1)$ $-COO-(CH_2)_n-O-C_6H_4-C_6H_4-CN$ IAc

Eine große Variabilität in Bezug auf die Strukturen IA und IE -IJ erlaubt das folgende Syntheseverfahren (M. Portugall, H. Ringsdorf, R. Zentel Makromol. Chem. 183, 2311 (1982); H, Ringsdorf, A. Schneller, Brit. Polym. J 13, 43 (1981).

Dabei wird aus der Verbindung XIII

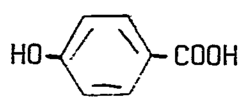 XIII

durch Umsetzung mit der Verbindung XIV in Gegenwart von Base

$HO-(CH_2)_n-Cl$ XIV

die Säure XV

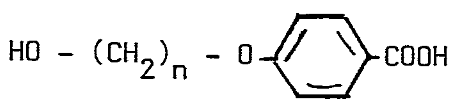 XV

hergestellt. Diese wird mit der (Meth)acrylsäure unter Säurekatalyse beispielsweise mit p-Toluolsulfonsäure in Chlorform in den (Meth)acrylsäureester XVI

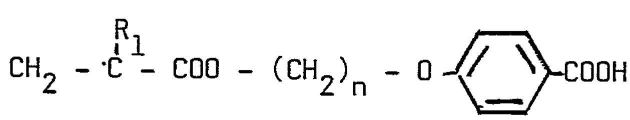 XVI

überführt. Die Verbindung XVI läßt sich z. B. analog III ins Säurechlorid überführen, das sich mit Phenol bzw. mit in p-Stellung substituierten Phenol in die Verbindung IE

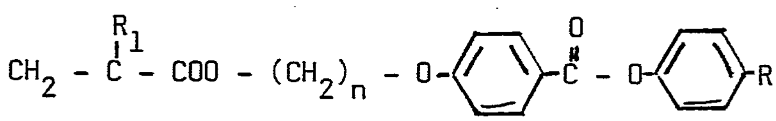 IE

bzw. die Verbindungen IE, IF, IG, IH, IJ überführen lässt.

Typ: Verknüpfung Spacer-Mesogene Gruppe über eine Estergruppe:
Als Beispiel sei die Herstellung einer Verbindung vom Typ IA beschrieben (Vgl. Plate et al. loc. cit.; Shibaev et al. loc. cit.) das Verfahren ist aber für die mesogenen Reste IA -IJ generell anwendbar. Dabei kann ausgehend von Verbindung IV mit einem der mesogenen Gruppen entsprechenden para-Phenol umgesetzt werden, etwa zur Verbindung XVII

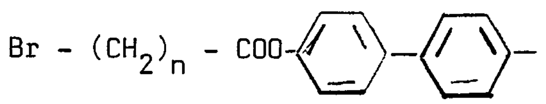

XVII

vorzugsweise in Gegenwart eines Säureakzeptors und in einem inerten Lösungsmittel wie THF.
Die weitere Umsetzung geschieht mit einem Salz der (Meth)acrylsäure Als Beispiel für Verbindungen, die ein chirales Zentrum R besitzen, sei die folgende Synthese erwähnt:
Man setzt ein Biphenyldiphenol der Formel XVIII

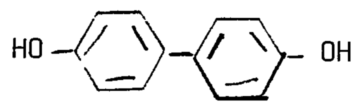

XVIII

mit dem Bromid der Formel XIV in Anwesenheit eines Alkalialkoholats

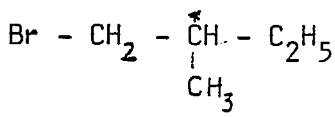

XIX

zu dem Phenol XX um.

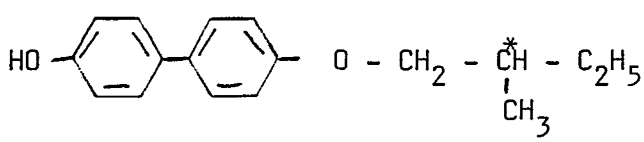

XX

Durch Umsetzung mit der Verbindung XIV in Ethanol unter Basenzusatz erhält man den Alkohol XXI

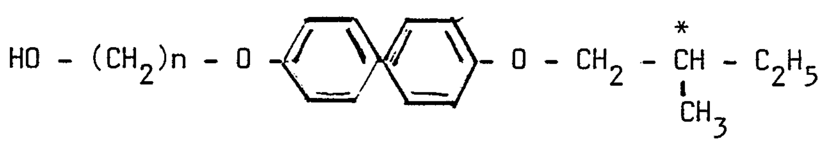

XXI

der mit (Meth)acrylsäure verestert wird.
Analog der Umsetzung XIV -XV kann aus der Verbindung XIV durch Umsetzung mit dem Phenol der Formel XXII in Gegenwart einer Base wie z. B. Pottasche in Aceton

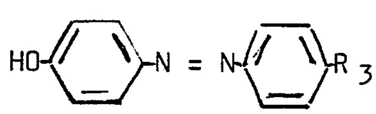

XXII

der Alkohol der Formel XXIII

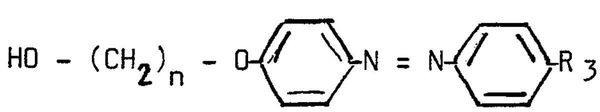

XXIII

hergestellt werden, der sich durch Umsetzung mit (Meth)acrylsäurechlorid in die Verbindung vom Typ IB

überführen läßt.

Säureamide der Formel I sind beispielsweise durch Umsetzung von (Meth)acrylsäurechlorid mit dem Amin der Formel XXIV

$$\underset{R_2}{HN} - (CH_2)_n - COOH \qquad XXIV$$

zum (Meth)acrylsäureamid XXV

$$CH_2 = \overset{R_1}{\overset{|}{C}} - CO - \overset{R_2}{\overset{|}{N}} - (CH_2)_n - COOH \qquad XXV$$

erhältlich, das beispielsweise mittels Umsetzung mit $Cl - \overset{O}{\overset{\|}{C}} - OCH_3$ in Gegenwart einer inerten Base mit einem Phenol, das die mesogene Gruppe enthält wie z. B. XXVI

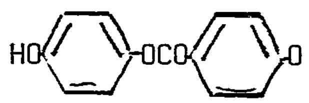 $- (CH_2)_m - H$ XXVI

in eine Verbindung des Typs ID übergeführt werden kann.

Polymerisation der Monomeren

Bei der Polymerisation der Monomeren, beispielsweise vom Typ I kann nach den Polymerisationsmethoden des Standes der Technik verfahren werden. (Vgl. Houben-Weyl, 4. Auflage Bd. 14/1, Georg Thieme Verlag 1961, H. Rauch-Puntigam, Th. Völker "Acryl-und Methacrylverbindungen, Springer-Verlag, Berlin 1967; Kirk-Othmer, 3rd Ed. Vol 18, J. Wiley 1982 Schildknecht, Skeist, Polymerization Processes, Vol. 29 of "High Polymers" Pg 133 (Wiley-Interscience 1977).

Zur Polymerisation der Verbindungen der Formel I kommt die radikalische Polymerisation in Frage. Genannt sei beispielsweise die Polymerisation in Lösung,in Suspension/Emulsion oder als Perlpolymerisation.

Man verwendet z. B. die üblichen Radikalinitiatoren, beispielsweise Azo-oder Perverbindungen (Vgl. Rauch-Puntigam, Völker, loc. cit, oder Brandrup-Immergut, Polymer Handbook loc.cit.)in den dafür vorgesehenen Mengen, beispielsweise 0,1 bis 1 Gew.-% bezogen auf die Monomeren. (Prototypen : Azoisobutylronitril, Dibenzoylperoxid, Dilauroylperoxid). Gegebenenfalls kann die Polymerisation durch Anwendung von Reglern wie beispielsweise die üblichen Schwefelregler gesteuert werden, im allgemeinen in Anteilen von 0,05 bis ca. 2 Gew.-% bezogen auf die Monomeren

(VGL. auch DE-A 10 83 548)

Es gelten ebenso die übliche Temperaturführung und die Aufarbeitungsmethoden.

Das Verfahren sei anhand der (Meth)acrylverbindungen der Formel I (A' = B' -X -Y entspricht

$$H_2 = \underset{R_1}{\underset{|}{C}} - \underset{O}{\underset{\|}{C}} - O - XY \quad bzw. \quad H_2 = \underset{R_1}{\underset{|}{C}} - \underset{O}{\underset{\|}{C}} - \underset{R_2}{\underset{|}{N}} - XY)$$

näher erläutert.

Polymerisationsverfahren in Lösung:

Ca. 0,35 Mol des Monomeren der Formel I werden in 850 ml Toluol gelöst. Dazu gibt man 1,8 mMol Azoisobutyronitril und erwärmt ca. 8 Stunden unter einem Inertgas bei ca. 333°K.
Das entstandene Polymer wird durch Fällen mit einem Fällungsmittel wie z. B. 1200 ml Methanol gewonnen, abgetrennt und durch Lösen in einem geeigneten Lösungsmittel wie z. B. Dichlormethan und erneutes Fällen mit Methanol gereinigt.
Anschließend kann das so erhaltene Material, in der Regel von Pulverkonsistenz,im Wasserstrahlvakuum bei etwa 303°K bis zur Gewichtskonstanz getrocknet werden.
Durch thermische Analyse wird die Glastemperatur und die Klärtemperatur bestimmt.

**Ansprüche**

1. Vorrichtung zur reversiblen optischen Datenspeicherung unter Verwendung von polymeren Flüssigkristallen mit mesogenen Seitengruppen, als Speichermedium eingerichtet zum Einspeichern von Information mittels selektiver Variation der Ordnung der polymeren Flüssigkristalle mittels einer Wärmequelle,
dadurch gekennzeichnet,
daß sich der makroskopisch orientierte Film aus dem flüssigkristallinen Polymern zum Zweck des Einspeicherns der Information im Temperaturbereich unterhalb der Glastemperatur $T_g$ T> $_a$ (Raumtemperatur im festen formstabilen Zustand des flüssigkristallinen Polymeren befindet, vermittels der Wärmequelle selektiv, lokal in den isotrop flüssigen Zustand aufgeheizt wird und nach Abschalten der Wärmequelle die örtliche Information im Glaszustand des Polymeren fixiert wird.

2. Vorrichtung gemäß Anspruch 1, dadurch gekennzeichnet, daß die polymeren Flüssigkristalle repetierende Einheiten der Formel I

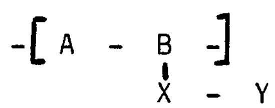

I

wobei A -B die Elemente der Hauptkette des Polymerisats, X eine abstandhaltende Einheit und Y eine mesogene Seitengruppe bezeichnet, enthalten.

3. Vorrichtung gemäß den Ansprüchen 1 und 2, dadurch gekennzeichnet, daß die Löschung der eingespeicherten Information selektiv lokal über eine Temperaturerhöhung und Abkühlung im elektrischen oder magnetischen Feld erfolgt, wodurch der ursprüngliche Orientierungszustand im lokalen Bereich wiederhergestellt wird.

4. Vorrichtung gemäß den Ansprüchen 1 und 2, dadurch gekennzeichnet, daß die Löschung der gesamten eingespeicherten Information und Wiederherstellung des Ausgangszustandes über eine Temperaturerhöhung und Abkühlung des Speichermediums im elektrischen oder magnetischen Feld erfolgt.

5. Vorrichtung gemäß den Ansprüchen 1 bis 4 dadurch gekennzeichnet, daß der Vorrichtung ein Laser als Wärmequelle zugeordnet ist.

6. Vorrichtung gemäß den Ansprüchen 1 bis 5, dadurch gekennzeichnet, daß das Absorptionsverhalten des Speichermediums so gewählt wird, daß die Information mit einem Laserstrahl geeigneter Wellenlänge und geeigneter Intensität eingespeichert und mit einem anderen Laserstrahl anderer Wellenlänge ohne Störung der Information ausgelesen werden kann.

7. Vorrichtung gemäß den Ansprüchen 1 bis 5, dadurch gekennzeichnet, daß die mesogenen Seitenketten des flüssigkristallinen Polymeren solche vom smektogenen Typ darstellen.

8. Vorrichtung gemäß den Ansprüchen 1 bis 5, dadurch gekennzeichnet, daß die flüssigkristallinen Polymeren aus Monomeren aufgebaut sind, die dem Acrylat-und/oder Methacrylattyp angehören.

9. Vorrichtung gemäß den Ansprüchen 1 bis 6, dadurch gekennzeichnet, daß die flüssigkristallinen Polymeren aus Monomeren aufgebaut sind, die dem Polyestertyp angehören.

10. Vorrichtung gemäß den Ansprüchen 1 bis 9, dadurch gekennzeichnet, daß die Variation des Ordnungszustands durch Anlegen eines elektrischen Felds erreicht wird.

11. Vorrichtung gemäß den Ansprüchen 1 bis 10, dadurch gekennzeichnet, daß sich der makroskopisch orientierte Film zwei übereinander angeordneten Platten oder Filmen befindet.

12. Vorrichtung gemäß den Ansprüchen 1 bis 11, dadurch gekennzeichnet, daß das flüssigkristalline Polymere eine Glastemperatur $T_g > T_a$ hat.

13. Vorrichtung gemäß den Ansprüchen 1 bis 12, dadurch gekennzeichnet, daß flüssigkristalline Polymere ein Molgewicht $\bar{M}n$ im Bereich $10^3$ bis $10^5$ hat.

14. Vorrichtung gemäß den Ansprüchen 1 bis 13, dadurch gekennzeichnet, daß das Speichermedium in seinem Absorptionsverhalten der Emissionswellenlänge des Schreiblasers angepasst ist.

15. Vorrichtung gemäß Anspruch 14, dadurch gekennzeichnet, daß das Speichermedium einen in seinem Absorptionsverhalten der Emissionswellenlänge des Schreiblasers angepassten Farbstoff enthält.

16. Vorrichtung gemäß Anspruch 14, dadurch gekennzeichnet, daß das flüssigkristalline Polymer durch Einpolymerisieren einer farbstoffhaltigen Comonomereinheit in seinem Absorptionsverhalten der Emissionswellenlänge des Schreiblasers angepasst ist.

17. Vorrichtung gemäß Anspruch 13 -15, dadurch gekennzeichnet, daß die erforderliche Extinktion des Speichermediums über die Farbstoffkonzentration eingestellt wird.

18. Vorrichtung gemäß den Ansprüchen 1 bis 17, dadurch gekennzeichnet, daß die Auslesewellenlänge außerhalb des für den Schreibprozeß relevanten Absorptionsmaximums des Farbstoffs liegt.

19. Verfahren zur reversiblen optischen Informationsspeicherung, dadurch gekennzeichnet, daß man - ausgehend von abbildungsfähigen materiellen Strukturen -die zu speichernde Struktur mittels einer kohärenten monochromatischen Lichtquelle beleuchtet, und das Interferenzmuster, das durch Richtung, Amplitude und Phasenlage des von der zu speichernden Struktur gestreuten Lichts relativ zu einer von der selben Lichtquelle stammenden Referenzlichtwelle bestimmt wird, in einer Vorrichtung enthaltend einen makroskopisch orientierten Film aus einem flüssigkristallinen Seitenkettenpolymeren als Speichermedium gemäß den Ansprüchen 1 bis 18 holographisch registriert und speichert.

20. Verfahren gemäß Anspruch 19, dadurch gekennzeichnet, daß das Auslesen der analog optisch gespeicherten Information durch Beleuchtung des makroskopisch orientierten Films mit monochromatisch kohärentem Licht erfolgt.

21. Verfahren zur reversiblen optischen Informationsspeicherung, dadurch gekennzeichnet, daß man zur Einspeicherung mittels eines Laserstrahls eine digitale Phasenstruktur in einem makroskopisch orientierten Film als Speichermedium der Vorrichtung gemäß den Ansprüchen 1 bis 18 erzeugt.

22. Verfahren gemäß Anspruch 21, dadurch gekennzeichnet, daß man den Laserstrahl und das Speichermedium sowohl beim Einspeichern als beim Auslesen der Information in definierter Weise relativ zu einander bewegt.

23. Verfahren gemäß Anspruch 22, dadurch gekennzeichnet, daß beim Einspeichern während des Bewegens die Intensität des Laserstrahls in geeigneter Weise moduliert wird.

24. Verfahren gemäß Anspruch 23, dadurch gekennzeichnet, daß beim Ein-Speicherungsvorgang auf digitalem Wege über eine vorzugebende Intensitätsmodulation eine Phasenstruktur im Speichermedium erzeugt wird und die Reproduktion durch Ausleuchten des gewonnenen synthetischen Hologramms mit einer Referenzwelle erfolgt.

25. Verfahren gemäß Anspruch 24, dadurch gekennzeichnet, daß die für die Erzeugung der Phasenstruktur erforderliche Intensitätsmodulation rechnerisch ermittelt wird.

26. Verfahren gemäß den Ansprüchen 19 bis 24, dadurch gekennzeichnet, daß die erzeugte Informationsdichte (ausgedrückt in Linien pro Längeneinheit) bezüglich aller drei Koordinatenachsen einerseits begrenzt wird durch die linearen Abmessungen des Speichermediums und andererseits durch maximal 2 000 Linien pro mm.

27. Verwendung der Vorrichtung gemäß den Ansprüchen 1 bis 18 zur reversiblen optischen Speicherung von Information.

28. Verwendung der Vorrichtung gemäß den Ansprüchen 1 bis 18, zur optischen Signalverarbeitung.

29. Verwendung der Vorrichtung gemäß Anspruch 28, zur Fourier-Transformation und -Faltung.

30. Verwendung der Vorrichtung gemäß den Ansprüchen 1 bis 18 zur Herstellung von Abbildungssystemen.

31. Verwendung der Vorrichtung gemäß den Ansprüchen 1 bis 18 zur Erzeugung und Speicherung von Hologrammen, die vergleichbare Abbildungseigenschaften haben wie Linsen.

32. Verwendung der Vorrichtung gemäß den Ansprüchen 1 bis 18 in der kohärent optischen Korrelationstechnik.

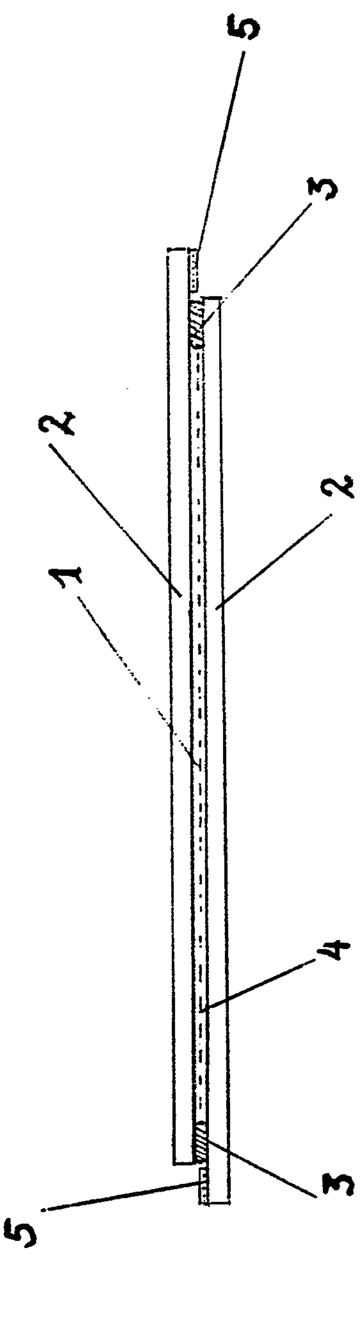


FIG. 1